# EUROPEAN PATENT APPLICATION

(11) **EP 2 261 965 A1**
(43) Date of publication of application: **15.12.2010**
(21) Application number: 09162632.5
(22) Date of filing: 12.06.2009
(51) Int. Cl.: H01L 21/60, H01L 23/485, H01L 23/498

(54) **Crimp bump interconnection**

(71) Applicant: NXP B.V., 5656 AG Eindhoven (NL)
(72) Inventor: Pischler, Erich, Redhill, Surrey RH1 1DL (GB)
(74) Representative: Williamson, Paul Lewis

(57) **Abstract**

The invention relates to a first integrated electronic component for an integrated electronic apparatus. The first integrated electronic component (100) comprises a male body (102) with a protrusion element (103), e.g. a bump. The protrusion element (103) comprises a protrusion connection section (104). The protrusion element (103) protrudes from the male body (102) in such a way that the protrusion connection section (104) is adapted for being mechanically connectable to a corresponding connection recess (202) of a female electrical conductive body (201), e.g. a conductive layer, of the second integrated electronic component (200).

## Description

### FIELD OF THE INVENTION

The invention relates to a first integrated electronic component and to a second integrated electronic component. Furthermore, the invention relates to an electronic apparatus and a method of connecting a first integrated electronic component with a second integrated electronic component.

### BACKGROUND OF THE INVENTION

For packaging semiconductor chips and for connecting the packaged semiconductor chip to a printed circuit board, a number of electric contacts have to be made. The ability to provide more and more I/O interconnections to a die (bare chip) that is increasingly shrinking in size is an important issue. In addition, the smaller size of the package contributes as much to the miniaturization of cell phones and other handheld devices as the shrinking of the semiconductor circuits.

Today, connections e.g. bumps on integrated circuits (IC) and chip packages are made for instance by soldering, conductive gluing or by applying an anisotropic conductive paste or foil (ACP, ACF). With these conventional connection methods, additional material has to be provided to the components to be connected and/or additional heat, ultrasonic power or other energy have to be provided to form a reliable connection.

For all these conventional connection techniques additional production steps, such as adding additional material and/or applying heat are necessary to connect two electronic components, e.g. to connect a semiconductor chip to a printed circuit board.

### OBJECT AND SUMMARY OF THE INVENTION

It may be an object of the present invention to enable a proper connection of integrated electronic components.

The object of the present invention may be achieved by a first integrated electronic component, a second integrated electronic component, an electronic apparatus and a method of connecting a first integrated electronic component with a second integrated electronic component according to the independent claims.

According to an exemplary embodiment of the present invention, a first (male) integrated electronic component for an integrated circuit is provided. The first integrated electronic component comprises a male body comprising a protrusion element. The protrusion element comprises a protrusion connection section. The protrusion element protrudes from the male body in such a way that the protrusion connection section is adapted for being mechanically connectable to a corresponding connection recess of a female electrical conductive body of a second integrated electronic component.

According to a further exemplary embodiment of the present invention, a second (female) integrated electronic component for an integrated electronic apparatus is provided. The second integrated electronic component comprises a female electrical conductive body with a connection recess. The connection recess is adapted for being mechanically connectable to a corresponding protrusion connection section of the protrusion element of the male body of the first integrated electronic component.

According to a further exemplary embodiment of the present invention, an electronic apparatus (unit) is provided. The electronic apparatus comprises a first integrated electronic component as described above and a correspondingly configured second integrated electronic component as described above. The first (male) integrated electronic component is connected with the second (female) integrated electronic component.

In particular, one of the first integrated electronic component and the second integrated electronic component forms at least a part of a chip or a chip package and the other one of the first integrated electronic component and the second integrated electronic component forms at least a part of a circuit board.

According to a further exemplary embodiment, a method of connecting a first integrated electronic component with a correspondingly configured second integrated electronic component is provided. According to the method, a protrusion connection section of a protruding element of a male body of the first integrated electronic component is mechanically connected to a corresponding connection recess of a female electrical conductive body of the second integrated electronic component.

The first integrated electronic component and/or the second integrated electronic component may define a semiconductor device such as an integrated circuit IC or a chip package, and/or a printed circuit board PCB, a substrate, and/or a leadframe. The integrated electronic component may also denote a monolithic integrated component.

The term "electrical conductive body" may denote an electrical conductive layer of the first integrated electronic component or the female electronic conductive layer. The "electrical conductive body" may also describe an electrical conductive leadframe.

The male body (layer) and/or the female electrical conductive body may be integrated, laminated or coated to a substrate or of a substrate forming multiple layer structure of an integrated circuit or a chip package, for example.

The term "protrusion element" may denote a connection element that protrudes from the male body (layer), so that the protrusion connection section of the protrusion element is formed that may be engaged by the connection recess of the second integrated electronic component. The connection recess of the second integrated electronic component may engage the protrusion connection section, so that a mechanical connection is generated. Thereby, the term "mechanically connectable" may describe a mechanical connection of two electrical components by a form closure, form fit, force closure, friction fit and/or a snap-fit connection. In other words, a mechanical connection may describe a connection between two electronic components without the need of further additional materials, such as further chemical substances, paste, foil, adhesives. Moreover, by the term "mechanical connection", a connection between two electronic components without the need of welded connections, soldered connections or any other connection methods requiring additional heat, ultrasonic power or other energy to form a reliable connection.

The "protrusion element" may also denote as crimp bump. Such a crimp bump may be formed as a bump of metal or any other material that is adapted for being mechanically connectable and/or that is adapted for being electrically conductive. The crimp bump may be formed by e.g. galvanic or electrolyse deposition, by engraving, or any other chemical, physical or mechanical process. The protrusion connection section may comprise a crimp section that comprises a larger diameter or size than the other sections of the protrusion connection section. The crimp may be formed by back etching, such as by or dipping in an etchant resistive solution or liquid, and etching the uncovered surfaces. Besides this, the crimp may also be formed by a mechanical process or by lasering.

The term "connection recess" of the second integrated electronic component may be a drill hole, a groove, a slot or a blind hole in the female electrical conductive body. The connection recess is adapted for engaging the protrusion connecting section so that a rigid mechanical connection may be generated.

The term "chip package" may particularly denote a housing that chips come in for plugging into (socket mount) or soldering onto (surface mount) a circuit board such as a printed circuit board, thus creating a mounting for a chip. In electronics, the term chip package or chip carrier may denote the material added around a component or integrated circuit to allow it to be handled without damage and incorporated into a circuit. Nowadays semiconductors manufacturers do apply BGA (ball grid array), QFN (Quad Flat No-Lead) and other leaded and leadless packages to provide a connectable semiconductor device to a system integrator (like a handheld manufacturer) who usually solders (or glues) the leads or contacts of the package, which are distributed two-dimensionally on the package, on a printed circuit board.

The term "circuit board" may particularly denote a support or mounting base on which a packaged chip such as a semiconductor chip is to be mounted. More particularly, printed circuit boards may be denoted as circuit boards comprising an insulator (for instance fibreglass), with threads of electrically conductive material serving as wires on the base of the board. The insulator may comprise one or numerous layers of material glued into a single entity. These additional layers may serve for a number of purposes, including providing grounding to the board. A printed circuit board, or PCB, may be used to mechanically support and electrically connect electronic components using conductive pathways, or traces, etched from copper sheets laminated onto a nonconductive substrate. A circuit board may also be a printed wiring board (PWB) or an etched wiring board.

Some mechanical tolerances of the male and second integrated electronic component should be taken into account to provide a reliable connection. Additional conductive glueing can be performed for a reliable connection.

The first integrated electronic component and the second integrated electronic component may be adapted for applying the surface-mount technology (SMT). In other words, the electronic apparatus may be manufactured by applying the surface-mount technology (SMT). The surface-mount technology (SMT) is a method for manufacturing electronic units (apparatus) in which the integrated electronic components (chips, chip packages, or Surface Mounted Components) are mounted directly onto the surface of printed circuit boards (PCBs). Electronic devices, units or apparatus so made are called surface-mount devices or SMDs. In the industry, it has largely replaced the through-hole technology construction method of fitting components with wire leads into holes in the circuit board.

By the present invention, electronic components, in particular in the field of (SMT-produced) semiconductor techniques such as chip packages and circuit boards, may be rigidly connected to each other easier and faster with only a few connection method steps. By using the claimed first (male) integrated electronic component and the second (female) integrated electronic component, a mechanical connection may be provided between each other so that further connection method steps, such as gluing or heat treatment steps may be unnecessary. In particular, a first integrated electronic component and a second integrated electronic component may be pressed together by only one production step. When connecting the first integrated electronic component and the second integrated electronic component by e.g. pressing, the protrusion connection section engages with the connection recess so that a rigid mechanical connection may be provided only by applying a mechanical force, such as a pressing force. Moreover, by connecting the electronic components by a mechanical connection, the electronic components may be detachably connected because no further adhesive or soldering material for example has to be removed before decoupling the electronic components. Thereby, mechanical connected electronic components may be reused in further assemblies or with further connection partners.

According to preferred embodiment, the male substrate body forms at least part of a chip package and the female substrate body or the female electrical conductive body forms at least part of a circuit board. It has turned out to be particularly advantageous to connect the protrusion element to a semiconductor chip packaging unit, whereas the provision of connection recesses is appropriate for a surface portion of a printed circuit board. However, in an alternative embodiment, it is possible that the role of first (male) and second (female) integrated electronic components are reversed, i.e. the male substrate body forms at least a part of a circuit board and the female substrate body forms at least part of a chip package.

According to a further exemplary embodiment the first integrated electronic component further comprises a male substrate body forming a multiple layer structure, wherein the male body is formed in (within, on) the male substrate body. The male body is formed in, within or on the (surface) of the male substrate body.

According to a further exemplary embodiment, the second integrated electronic component comprises a female substrate body forming a multiple layer structure. The female electrical conductive body is formed in, within or on the (surface) of the female substrate body.

The female substrate body may form a blind hole or through hole engaging the protrusion connection section of the first integrated electronic component, so that the protrusion connection section is engaged with the connection recess. Besides the mechanical connection between the protrusion connection section and the connection recess, also a mechanical connection between the protrusion connection section and the female substrate body may be provided. Thus, a stronger mechanical connection may be provided.

The term "substrate body" may denote any suitable material, such as a semiconductor like silicon, a dielectric material like glass or plastic, or a metal or metallic foil. According to an exemplary embodiment, the term "substrate" may be used to define generally the elements for layers that underlie and/or overlie a layer or portions of interest, i.e. the substrate body may form a multilayer structure. In addition, the substrate may be any other base on which layers, such as the male (electrical conductive) body (layer) or the female electrical conductive body, may be formed or a component is to be mounted. The male/female (electrical conductive) body (layer) may be formed on the surface of the substrate body, within the substrate body and/or in the substrate body. The substrate body may be or may be part of a wafer level chip scale package (WLCSP) for packaging a semiconductor chip. Such a semiconductor chip may be particularly a silicon chip formed by microtechnology. As an alternative to silicon technology, any other group IV semiconductor technology may be used such as germanium technology. It is also possible that a group III group V semiconductor technology such as gallium arsenide technology is used for forming at least part of the connection component.

According to a further exemplary embodiment of the first integrated electronic component, the protrusion connection section is formed in such a way that the protruding connection is press-fit connectable to the corresponding connection recess.

According to a further exemplary embodiment of the second integrated electronic component, the connection recess is formed in such a way that the connection recess is press-fit connectable to the corresponding protrusion connection section.

For applying a press-fit connection or an interference fit connection, the size (e.g. diameter) of the protrusion connection section may be larger than the size (diameter) of the connection recess, so that a friction force and a pressing force is generated that prevents the first (male) integrated electronic component from decoupling from the second (female) integrated electronic component. The friction force holds the electronic components together in particular by increasing the compression of the protrusion connection section inside the connection recess. By using the press-fit connection, the first integrated electronic component and the second integrated electronic component may be detached easily because e.g. no solder connection or further connection mechanisms that fixes the first integrated electronic component to the second integrated electronic component may be necessary.

According to a further exemplary embodiment of the first integrated electronic component, the protrusion connection section is formed in such a way that the protrusion connection section is snap-fit connectable to the corresponding connection recess.

According to a further exemplary embodiment of the second integrated electronic component, the connection recess is formed in such a way that the connection recess is snap-fit connectable to the corresponding protrusion connection section.

For using a snap-fit connection, the protrusion connection section and the connection recess may comprise an edge or an undercut so that the edge of the one electronic component may be form-fit connected to the undercut of the other corresponding electronic component. Thus, a rigid connection by applying a form-fit connection may be provided so that the risk of an unintended decoupling of the electronic components may be reduced.

According to a further exemplary embodiment of the first integrated electronic component, the protrusion element and the male substrate body (layer) is electrically conductive so that an electrical connection to the female electrical conductive body is generatable, additionally to the mechanical connection.

According to a further exemplary embodiment of the second (female) integrated electronic component, the connection recess is formed in such a way that an electrical connection with the protrusion connection section of the first integrated electronic component is generatable.

Thereby, the connection between the first integrated electronic component and the second integrated electronic component may comprise two functions. Firstly, by the mechanical connection a rigid connection between both components may be provided and secondly, an electrical connection between both components may be provided. Thus, no further separate connections, one for the mechanical connection and one for the electrical connection, may be necessary. Thus, by the same connection step or manufacturing step both, the electrical and mechanical connection between both parts may be provided. Further separate production steps for a mechanical connection and additionally for the electrical connection may not be necessary. Thus, the production method may be faster and costs for manufacturing the connection of the first integrated electronic components and the second integrated electronic components may be reduced. Moreover, the de-mounting by un-soldering of the electronic apparatus comprising two interconnected first and second integrated electronic components may not be possible. Thus, the electronic apparatus may be not that easily hacked by contacting the conventional pins and re-soldering it on the board/substrate. Hence, the security, that may be particularly important for smart card controller ICs, may be improved.

For providing the electrical conductive connection between the first integrated electronic component and the second integrated electronic component, the protrusion elements may be electrically conductive by using a conductive material, such as metal or other materials with conductive characteristics. Furthermore, the recess itself may be formed in the female electrical conductive body. Moreover, a bushing (e.g. with electrical conductive characteristics) may be inserted into the connection recess for providing the electrical connection.

According to a further exemplary embodiment of the first integrated electronic component, the protrusion element is formed integrally with the male body (layer). Thus, the male body, e.g. the male electrical conductive layer, and the protrusion element may be formed in one piece so that a faster production method may be provided because no individual parts have to be manufactured separately. Moreover, by providing the protrusion element integrally with the male electrical conductive layer a loss of electrical signal power over the interface between both parts, the electrical conductive layer and the protrusion element, may be prevented.

According to a further exemplary embodiment of the first integrated electronic component, the protrusion element is detachably mounted to the male body (layer). The protrusion element may be for instance etched, glued or connected by connection means to the male body. However, by applying a detaching force, the protrusion element may be detached from the male electrical conductive layer. Thus, the protrusion element may be exchanged for instance when either the male electrical conductive layer or the protrusion element is damaged. Thus, when one protrusion element is damaged for instance, it is not necessary to exchange the male body. Thus, maintenance costs may be reduced.

Moreover, by attaching protrusion elements individually to the male body, a male electrical conductive layer may be produced for a large variety of separate second integrated electronic components. By providing a detachable protrusion element, the protrusion element may be adjusted and aligned with its geometry to the corresponding connection recesses of the second integrated electronic components, whereby at the same time for a variety of different second integrated electronic components an identically formed first integrated electronic component may be used. In other words, only the protrusion elements are adjusted to the different sizes of the connection recesses of the different second integrated electronic components. The same first integrated electronic component may be formed for a large variety of different second integrated electronic components. Thus, manufacturing costs may be reduced.

According to a further exemplary embodiment of the first integrated electronic component, the material of the protrusion element differs to the material of the male electrical conductive layer. Thus, by using the different material, the characteristics of each material may be adjusted according to its use. In particular, it may be beneficial if the material of the protrusion element is harder than the male electrical conductive layer because higher mechanical forces due to the mechanical connection are applied to the protrusion element. On the other side, it may be more advantageous if the male body (layer) provides better electrical conducting characteristics. Thus, for each application and specification optimal material characteristic may be provided, so that for instance the overall weight, the electrical conductive characteristics and the shelf life may be improved.

According to a further exemplary embodiment of the first integrated electronic component, the profile of the protrusion connection section forms a crimp anvil shape. The crimp anvil shape or the mushroom shape profile of the protrusion connection section may improve the mechanical connection to the connection recess for instance when using a snap-fit connection or a form-fit connection. The crimp anvil shape may be easily produced by dipping the protrusion connection section in an etchant resistive solution wherein uncovered surfaces of the protrusion connection section may be etched so that the desired crimp anvil shape may be produced.

According to a further exemplary embodiment, the profile of the protrusion connection section of the protrusion element forms a tapering cylindrical, pyramidal or polygonal shape. Thus, by the large variety of possible shapes, an adaption to corresponding connection recesses may be provided so that for a large variety of differently shaped connection recesses a mechanical connection may be provided.

According to a further exemplary embodiment, the female connection body comprises an electrically conductive leadframe. The leadframe may comprise e.g. a perforated copper sheet to which the first integrated electronic component, such as a chip, may be mechanically connected.

According to a further exemplary embodiment, the second integrated electronic component is adapted for being connectable with a correspondingly formed first integrated electronic component as described above.

The first integrated electronic component may comprise also a plurality of protrusion elements. Each of the protrusion elements may be connectable to a second integrated electronic component or to different second integrated electronic components. Moreover, the first integrated electronic component may furthermore comprise connection recesses adapted for being mechanically connectable to a corresponding protrusion connection section of other electronic components. Hence, also the second integrated electronic component may comprise besides the connection recess also at least one protrusion element for being mechanically connected to connection recesses of further electronic components.

By the present invention, a mechanical connection, e.g. a crimp bump interconnection, is provided. Thereby the protrusion element may form a protrusion connection section formed with e.g. a crimp bump profile. Hence, a crimp bump interconnection may be provided with a conductive connection between e.g. a semiconductor device and an application board (PCB) or a metal leadframe. The interconnection is made by mechanical forces (mechanical connection) so that the (metal) protrusion element (bump) is pressed with its crimp into the connection recess (e.g. a metal coated drill hole). By bending off a crimp of the protrusion element, friction between the metal surface of the connection recess and the protrusion element may be generated and a reliable rigid connection may be provided. This method may replace soldering of semiconductor devices onto substrates, boards, leadframes, etc and may therefore lead to a faster and inexpensive production process.

These and other aspects of the invention are apparent from and will be elucidated with reference to the embodiments described hereinafter.

### BRIEF DESCRIPTION OF THE DRAWINGS

The invention will be described in greater detail hereinafter, by way of nonlimiting examples, with reference to the embodiments shown in the drawings.
Fig. 1 illustrates a first integrated electronic component for being connectable to a second integrated electronic component according to an exemplary embodiment of the invention;
Fig. 2 illustrates a second integrated electronic component according to an exemplary embodiment of the present invention;
Fig. 3 illustrates an electronic apparatus comprising the first integrated electronic component of Fig. 1 and the second integrated electronic component shown in Fig. 2 according to an exemplary embodiment of the present invention;
Fig. 4 illustrates a further exemplary embodiment of the second integrated electronic component according to the present invention;
Fig. 5 illustrates an electronic apparatus comprising a first integrated electronic component shown in Fig. 1 and a second integrated electronic component shown in Fig. 4 according to an exemplary embodiment of the present invention;
Fig. 6a and Fig. 6b illustrate schematically a view of a connection recess engaging the protrusion element according to an exemplary embodiment of the present invention; and
Fig. 7 illustrates a manufacturing process of the protrusion element according to an exemplary embodiment of the invention.

### DESCRIPTION OF EMBODIMENTS

The illustrations in the drawings are schematically. In different drawings, similar or identical elements are provided with the same reference signs.

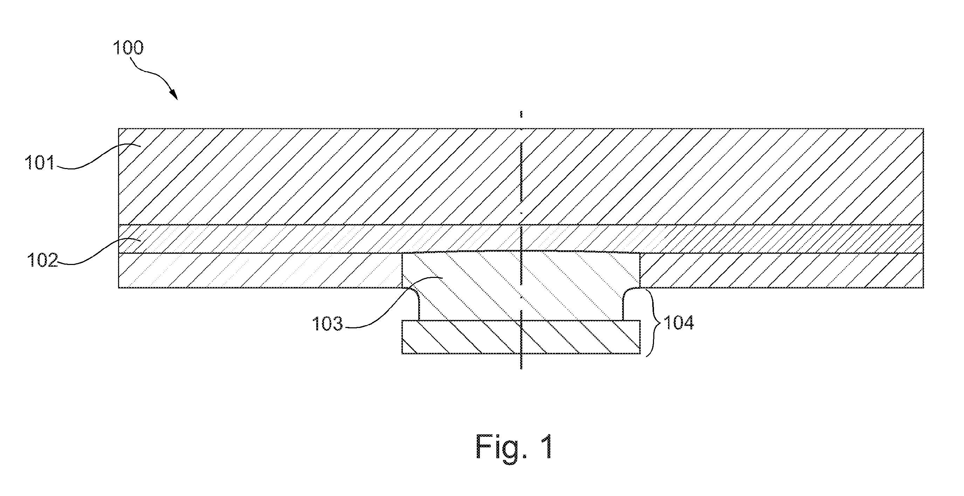

**Fig. 1** illustrates a first (male) integrated electronic component 100 for being connectable to a correspondingly configured second (female) integrated electronic component 200. The first integrated electronic component 100 comprises a male body 102 with a protrusion element 103. The protrusion element 103 protrudes from the male body 102 in such a way that the protrusion element 103 forms a protrusion connection section 104 adapted for being mechanically connectable to a corresponding connection recess 202 of a female electrical conductive body 201 of the second integrated electronic component 200.

As shown in Fig. 1, the male body 102 may be formed as a male electrical conductive layer that is formed inside a male substrate body 101. The male body 102 may also be formed onto a surface of the male substrate body 101. The male substrate body 101 may be a multilayer substrate structure.

From the male body 102 the protrusion element 103 protrudes. The protrusion element 103 may be an integrated part of the male body 102, so that both, the male body 102 and the protrusion element 103, forms one piece. Besides that, the protrusion element 103 may be a separate part and/or detachably connected to the male body 102. Thereby, the protrusion element 103 may be formed of a different material than the electrical conductive body 102.

In the section of the protrusion element 103 where the mechanical connection with a second integrated electronic component 200 may be provided, the protrusion element 103 forms a protrusion connection section 104. The protrusion connection section 104 may be adapted with respect to a corresponding connection recess 202 in order to provide a mechanical connection. Thus, the protrusion connection section 104 may provide a larger diameter or size than the corresponding connection recess in order to generate a form-fit or press-fit connection. As shown in Fig. 1, the shape of the protrusion connection section 104 of the protrusion element 103 may be a crimp bump or a crimp-anvil profile that provides a flange or edge with a larger diameter and a middle section with a smaller diameter so that an undercut is formed. By means of such a crimp-anvil profile or mushroom-shaped profile a form closure or form-fit with a corresponding connection recess 202 may be provided in order to achieve a strong mechanical connection.

The protrusion element 103 may be formed of an electrical conductive material so that by the protrusion element 103 a mechanical connection as well as an electrical connection may be provided. Thus, further an electrical connection besides the connection with the protrusion element 103 may not be necessary.

Moreover, the male body 102 may comprise a plurality of protrusion elements 103 for providing a mechanical connection with corresponding connection recesses 202.

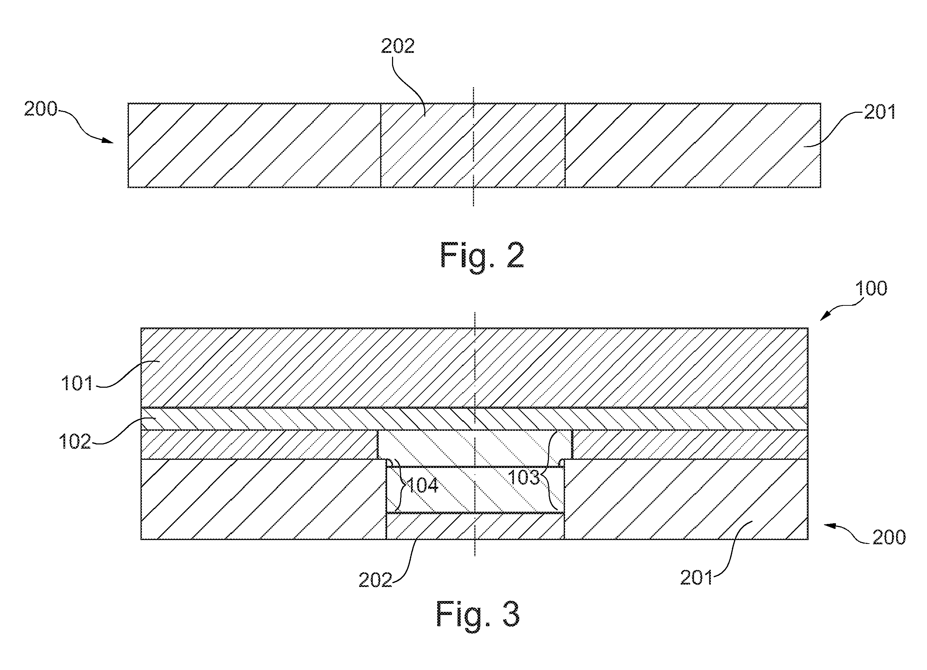

**Fig. 2** illustrates an exemplary embodiment of the second integrated electronic component 200. The second integrated electronic component may comprise a female electrical conductive body 201 and the connection recess 202. In the embodiment of Fig. 2, the female electrical conductive body 201 may form a leadframe, for instance. The connection recess 202 is adapted for being mechanically connectable to a corresponding protrusion connection section 104 of the protrusion element 103 in order to provide the mechanical connection with the first integrated electronic component 100. In the connection recess 202 a bushing may be inserted in order to improve the mechanical connection or the electrical conductivity. Moreover, by the bushing, the size of the connection recess may be adapted to various sizes of corresponding protrusion elements 103. Moreover, the profile of the connection recess 202 may form a flange or an edge with an undercut in order to provide a form closure or a form-fit connection with the corresponding protrusion element 103, e.g. with a crimp-anvil profile. Moreover, the female electrical conductive body 201 may provide a plurality of connection recesses 202 for providing a mechanical connection with a plurality of corresponding protrusion elements 103.

**Fig. 3** illustrates an electronic apparatus comprising the first integrated electronic component 100 shown in Fig. 1 and the second integrated electronic component 200 shown in Fig. 2. The first integrated electronic component 100 is mechanically connected with the second integrated electronic component 200, wherein one of the first integrated electronic components 100 and the second integrated electronic components 200 forms at least a part of a chip or a chip package and the other one of the first integrated electronic component 100 and the second integrated electronic component 200 forms at least a part of a circuit board.

As can be seen in Fig. 3, the protrusion connection section 104 is engaged by the connection recess 202 in order to provide a mechanically connection. Moreover, when the protrusion element 103 and the connection recess 202 provide an electrical connection, besides a mechanical connection of the first integrated electronic component 100 and the second integrated electronic component 200 an electrical connection may be generated as well.

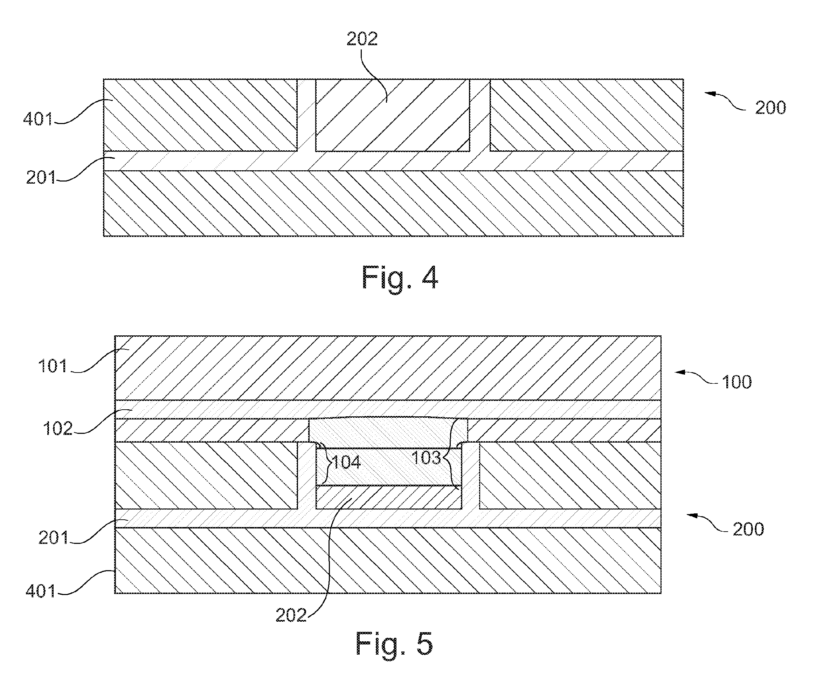

**Fig. 4** illustrates a further exemplary embodiment of the present invention wherein the second integrated electronic component 200 further comprises a female substrate body 401. The female electrical conductive body 201 may be formed in, within or on the female substrate body 401.

**Fig. 5** illustrates an electronic apparatus according to an exemplary embodiment of the present invention wherein the first integrated electronic component 100 as shown in Fig. 1 is mechanically connected with the exemplary embodiment of the second integrated electronic component 200 as shown in Fig. 4.

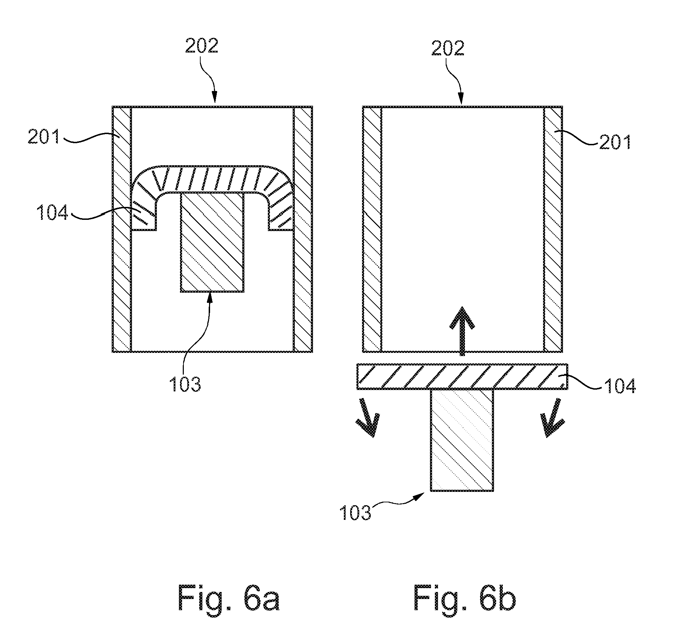

**Fig. 6a and Fig.6b** illustrate schematically a view of the connection recess 202 of the female electrical conductive body 201 engaging the protrusion connection section 104 of the protrusion element 103. The size, i.e. the diameter, of the protrusion connection section 104 may be larger than the size, i.e. the diameter, of the connection recess 202, so that the mechanical connection, i.e. the press fit connection, may be provided.

In particular as shown in Fig. 6a and Fig.6b, the protrusion connection section 104 may be flexible or bendable. Thus, edges of the protrusion connection section 104 may be bended when the protrusion element 103 may be introduced into the connection recess 202. Thus, by choosing the material of the protrusion element 103 a predetermined press capacity may be provided. Moreover, as can be taken from Fig. 6a, the surface of the edges of the protrusion connection section 104 that is in contact with the inner surface of the connection recess 202 may be enlarged in comparison to the not bended lateral face of the protrusion connection section 104.

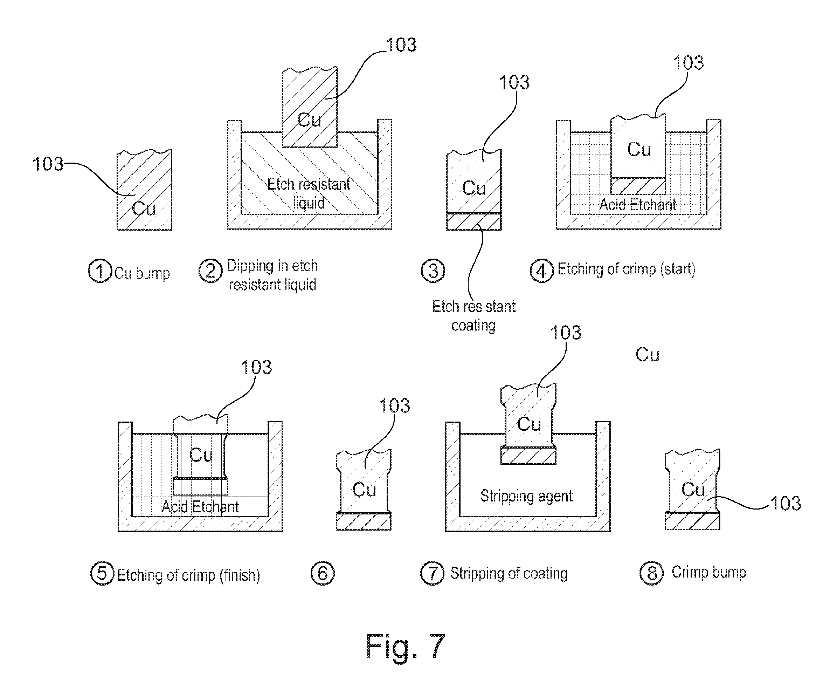

**Fig. 7** illustrates an exemplary manufacturing process of the protrusion element 103 in particular with a mushroom-like (or crimp-anvil) profile. The billet of the protrusion element 103 is first dipped in an etch-resistant liquid. The etch-resistant liquid is coated to those sections where the edge or the flange should be formed. Next, the protrusion element 103 is dipped in an acid etchant wherein the etchant etches the section of the protrusion element 103 where no etch resistant liquid is coated. Next, the protrusion element 103 is dipped into a stripping agent wherein the etch-resistant liquid is stripped from the protrusion element 103. Finally, a protrusion element 103 is manufactured that provides a mushroom-like profile comprising an undercut and a flange or edge.

Finally, it should be noted that the above-mentioned embodiments illustrate rather than limit the invention, and that those skilled in the art will be capable of designing many alternative embodiments without departing from the scope of the invention as defined by the appended claims. In the claims, any reference signs placed in parentheses shall not be construed as limiting the claims. The word "comprising" and "comprises", and the like, does not exclude the presence of elements or steps other than those listed in any claim or the specification as a whole. The singular reference of an element does not exclude the plural reference of such elements and vice-versa. In a device claim enumerating several means, several of these means may be embodied by one and the same item of software or hardware. The mere fact that certain measures are recited in mutually different dependent claims does not indicate that a combination of these measures cannot be used to advantage.

### List of reference signs:

- 100: first integrated electronic component
- 101: male substrate body
- 102: male body
- 103: protrusion element
- 104: protrusion connection section

- 200: second integrated electronic component
- 201: female electrical conductive body
- 202: connection recess
- 203: leadframe

- 401: female substrate body

## Claims

1. A first integrated electronic component for an integrated electronic apparatus, the first integrated electronic component (100) comprising
a male body (102) with a protrusion element (103),
wherein the protrusion element (103) comprises a protrusion connection section (104),
wherein the protrusion element (103) protrudes from the male body (102) in such a way that the protrusion connection section (104) is adapted for being mechanically connectable to a corresponding connection recess (202) of a female electrical conductive body (201) of a second integrated electronic component (200).

2. The first integrated electronic component of claim 1, further comprising a male substrate body (101) forming a multiple layer structure,
wherein the male body (102) is formed in the multiple layer structure.

3. The first integrated electronic component of claim 1 or 2,
wherein the protrusion connection section (104) is formed in such a way that the protrusion connection section (104) connectable to the corresponding connection recess (202) by forming at least one of a press fit connection and a snap fit connection.

4. The first integrated electronic component of one of the claims 1 to 3,
wherein the protrusion element (103) and the male body (102) are electrically conductive, so that an electrical connection to the female electrical conductive body (201) is generatable when mechanically connected.

5. The first integrated electronic component of one of the claims 1 to 4,
wherein the protrusion element (103) is formed integrally with the male body (102).

6. The first integrated electronic component of one of the claims 1 to 5,
wherein the protrusion element (103) is detachably mounted to the male body (102).

7. The first integrated electronic component of claim 6,
wherein the material of the protrusion element (103) differs from the material of the male body (102).

8. The first integrated electronic component of one of the claims 1 to 7,
wherein the profile of the protrusion connection section (104) of the protrusion element (103) forms a, crimp anvil shape, a tapering shape, a cylindrical shape, a pyramidal shape or a polygonal shape.

9. A second integrated electronic component for an integrated electronic apparatus, the second integrated electronic component (200) comprising
a female electrical conductive body (201) with a connection recess (202), wherein the connection recess (202) is adapted for being mechanically connectable to a corresponding protrusion connection section (104) of a protrusion element (103) of a male body (102) of the first integrated electronic component (100).

10. The second integrated electronic component of claim 9,
wherein the connection recess (202) is formed in such a way that the connection recess (202) is connectable to the corresponding protrusion connection section (104) by forming at least one of a press fit connection and a snap fit connection.

11. The second integrated electronic component of one of the claims 9 to 10,
wherein the connection recess (202) is formed in such a way that an electrical connection with the protrusion connection section (104) of the first integrated electronic component (100) is generatable.

12. The second integrated electronic component of one of the claims 9 to 11,
wherein the female connection body comprises an electrically conductive leadframe (203).

13. The second integrated electronic component of one of the claims 9 to 12, further comprising
a female substrate body (401) forming a multiple layer structure,
wherein the female electrical conductive body (201) is formed in the female substrate body (401).

14. The second integrated electronic component of one of the claims 9 to 13, adapted for being connectable with a correspondingly configured first integrated electronic component (100) according to one of the claims 1 to 8.

15. An electronic apparatus, comprising
a first integrated electronic component (100) of one of the claims 1 to 8, and
a correspondingly configured second integrated electronic component (200) one of the claims 9 to 14,
wherein the first integrated electronic component (100) is mechanically connected with the second integrated electronic component (200).

16. A method of connecting a first integrated electronic component (100) with a correspondingly configured second integrated electronic component (200), the method comprising
mechanically connecting a protrusion connection section (104) of a protrusion element (103) of a male body (102) of the first integrated electronic component (100) to a corresponding connection recess (202) of a female electrical conductive body (201) of the second integrated electronic component (200).

## Amended claims

### Amended claims in accordance with Rule 137(2) EPC.

**1.** Apparatus comprising a first integrated electronic component and a second integrated electronic component for an integrated electronic apparatus, the first integrated electronic component (100) comprising
a male body (102) with a protrusion element (103) comprising a protrusion connection section (104),
the second integrated, electronic component (200) comprising
a female electrical conductive body (201) with a connection recess (202), wherein the protrusion element (103) protrudes from the male body (102) in such a way that the protrusion connection section (104) is adapted for being mechanically connectable to the connection recess (202), and
wherein the protrusion connection section (104) is flexible or bendable and is connectable to connection recess (202) by forming a press fit connection.

**2.** The apparatus of claim 1, wherein the first integrated electronic component further comprises a male substrate body (101) forming a multiple layer structure, wherein the male body (102) is formed in the multiple layer structure.

**3.** The apparatus of claim 1 or claim 2, wherein the protrusion element (103) and the male body (102) are electrically conductive, so that an electrical connection to the female electrical conductive body (201) is generatable when mechanically connected.

**4.** The apparatus of any preceding claim, wherein the protrusion element (103) is formed integrally with the male body (102).

**5.** The apparatus of any preceding claim, wherein the protrusion element (103) is detachably mounted to the male body (102).

**6.** The apparatus of claim 5, wherein the material of the protrusion element (103) differs from the material of the male body (102).

**7.** The apparatus of any preceding claim, wherein the profile of the protrusion connection section (104) of the protrusion element (103) forms a, crimp anvil shape, a tapering shape, a cylindrical shape, a pyramidal shape or a polygonal shape.

**8.** The apparatus of any preceding claim, wherein the female connection body comprises an electrically conductive leadframe (203).

**9.** The apparatus of any preceding claim, wherein the second integrated electronic component further comprises a female substrate body (401) forming multiple layer structure, wherein the female electrical conductive body (201) is formed in the female substrate body (401).
